# EUROPEAN PATENT SPECIFICATION

(11) **EP 0 532 758 B1**
(45) Date of publication and mention of the grant of the patent: **29.11.1995**
(21) Application number: 92904980.7
(22) Date of filing: 12.02.1992
(51) Int. Cl.: H01L 21/31, H01L 21/00

(54) **CVD SEMICONDUCTOR MANUFACTURING EQUIPMENT**
CVD VORRICHTUNG ZUM HERSTELLEN VON HALBLEITERN
INSTALLATION A DEPOT CHIMIQUE EN PHASE VAPEUR POUR LA FABRICATION DE SEMICONDUCTEURS

(30) Priority: 15.02.1991 JP 22358/91
(43) Date of publication of application: 24.03.1993
(73) Proprietor: SEMICONDUCTOR PROCESS LABORATORY CO., LTD., Minato-ku, Tokyo 108 (JP); CANON SALES CO., INC., Minato-ku, Tokyo 108 (JP); ALCAN-TECH CO., INC., Tokyo 108 (JP)
(72) Inventor: MAEDA, Kazuo Semiconductor Process Lab. Co. Ltd., Minato-ku Tokyo 108 (JP); OHIRA, Kouichi Semiconductor Process Lab. Co. Ltd., Minato-ku Tokyo 108 (JP); HIROSE, Mitsuo, Minato-ku Tokyo 108 (JP)
(74) Representative: Marx, Lothar, Dr.
(86) International application number: PCT/JP92/00135
(87) International publication number: WO 92/15114

(56) References cited:
- EP-A- 0 252 667
- JP-A-63 076 334
- US-A- 3 541 675

## Description

The present invention relates to an endless track, continuous type CVD apparatus for manufacturing semiconductor devices for forming a film on a wafer by a chemical vapor deposition (CVD) method, as defined in the claim 1.

As to film formation by a CVD method in a mass production scale,
(1) batch type CVD apparatus,
(2) continuous CVD apparatus including;
   (a) conveyor type,
   (b) walking beam type, and
(3) multi-chamber type CVD apparatus have been heretofore used principally.

The batch type CVD apparatus has a high mass-productivity, but is not suitable for making a process on the basis of increase in a diameter of a wafer and production control of individual wafer precise. Moreover, a throughput thereof is not necessarily high because of slow processing speed.

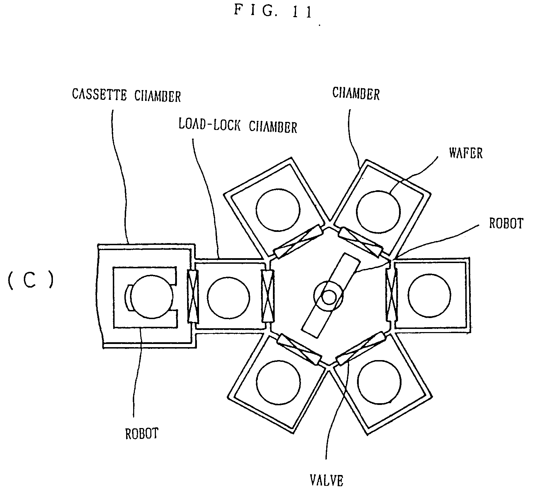

Further, a multi-chamber type CVD apparatus shown in Fig. 11(c) is principally used for film formation under reduced pressure, and respective chambers are provided independently of one another. Therefore, various different processings are possible and flexibility is high, but the throughput is appreciably low.

Accordingly, when increase of the diameter of the wafer, high throughput and the like are required, the continuous type CVD apparatus is advantageous originally.

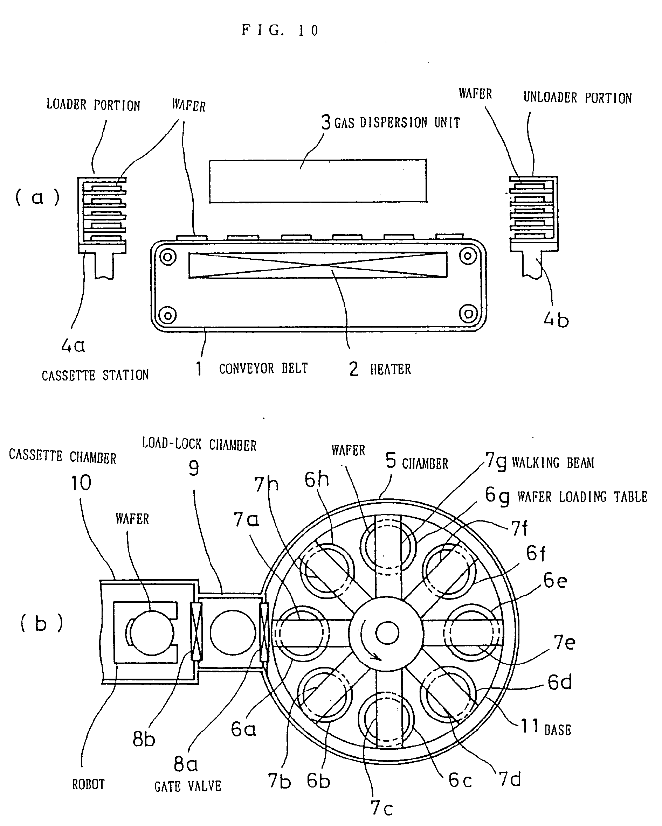

Fig. 10(a) illustrates a conveyor type continuous CVD apparatus, which is used principally for film formation under atmospheric pressure. A reference numeral 1 represents a conveyor belt, 2 represents a heater provided under the conveyor belt which is an area where a film is formed on a wafer, being separated from the conveyor belt 1 and fixed thereto, 3 represents a gas dispersion unit provided above the conveyor belt 1 which serves as an area for forming a film on a wafer, and 4a and 4b represent cassette stations of a loader section and an unloader section. In such an apparatus, wafers are placed on the conveyor belt 1 and progressed one after another. Further, since the heater 2 is installed fixedly under the conveyor belt 1, the wafers are heated indirectly by radiation.

Fig. 10(b) illustrates a continuous type CVD apparatus of a walking beam system, which is used principally for film formation by a plasma CVD method and the like under reduced pressure. A reference number 5 in the Figure represents a chamber, and 6a to 6h represent a plurality of wafer loading tables each equipped with a heater, which are fixed to a base table 11. 7a to 7h represent eight pieces of walking beams arranged rotatably around the rotary shaft while holding the wafers, 8a and 8b represent gate valves, 9 represents a load lock chamber connected to the chamber 5 through gate the valve 8a, and 10 represents a cas sette chamber connected to the load lock chamber 9 through the gate valve 8b.

A film is formed using such an apparatus in such a manner as described hereunder. Namely, first, a wafer is loaded on the wafer loading table 6a in the chamber 5 from the load lock chamber 9, and heated to a predetermined temperature by means of a heater located underneath the wafer loading table 6a. Then, the wafer is held by the walking beam 7a after forming a film on the wafer located on the wafer loading table 6a, and is moved and loaded on the wafer loading table 6b where following film formation is performed. At this time, the next wafer is also loaded on the wafer loading table 6a in the chamber 5 from the load lock chamber 9, and heated to a predetermined temperature by a heater located underneath the wafer loading table 6a. Then, films are formed on the wafers on the wafer loading tables 6a and 6b.

The wafers are introduced into the chamber 5 in consecutive order in this manner, and films are formed continuously on the surfaces of the wafer heated and thermally insulated by means of the heater on respective wafer loading tables 6a to 6h while moving the wafers on the fixed wafer loading tables 6a to 6h one after another. Accordingly, when the wafer goes round on respective wafer loading tables 6a to 6h, a film of different types formed of a multi-layer or a film of a single layer having a predetermined film thickness is formed for instance.

Now, the above-described continuous type CVD apparatus which e.g. is known from JP-A-63-76334, has such problems as described hereunder.
(1) As to the conveyor type, since the wafer moves and the heater 2 is fixed, it is difficult to measure the temperature of the wafer. Moreover, since the heater 2 underneath the conveyor belt 1 is installed apart from the conveyor belt 1 in some measure, it is impossible to control the temperature of the wafer precisely.
(2) Also, as to the walking beam type, since the wafer parts from the wafer loading tables 6a to 6h while mov ing, it is unavoidable that the temperature of the wafer is lowered. Thus, the wafer is subject to a temperature cycle midway in film formation, and distortion remains in a formed film sometimes. Since it is required to heat the wafer again so that the wafer temperature reaches a predetermined temperature when the wafer moves from the wafer loading table 6a to the next wafer loading table 6b, it takes time to stabilize the wafer temperature, thus making adjustment thereof complicated.

The prior art document EP-A-252 667 discloses a chemical vapor deposition apparatus. This apparatus includes a gas dispersion unit composed of two gas reaction introducing nozzles and an inert gas introducing multiple nozzle plate. This arrangement should provide a gas distribution in the processing chamber which should be equalized and guarantee equal film thicknesses over a considerable area of the wafer loading surface.

The prior art document US-A-3,541,675 shows a chip support apparatus and a device for ultrasonic welding. To supply an electrical current or electrical voltage to the welding apparatus, electrodes are provided and individual spring fingers are provided to retain these electrodes.

In order to solve the above problems, it is conceivable that the wafer holder equipped with a heater is fixed and the gas dispersion unit is moved. However, there is a problem that it becomes no longer possible to process the wafers continuously in a mass production scale because the wafers do not move.

It is an object of the present invention which has been made in view of such conventional problems to provide an apparatus for manufacturing a semiconductor device in which the wafer can be moved while maintaining the wafer temperature at a predetermined temperature and it is possible to perform production control of individual wafer and form multi-layer films of different types.

These objects are solved by a CVD apparatus including the features of claim 1. Advantageous embodiments of this CVD apparatus are defined by the features listed in the subclaims.

The advantages to be attained by the present invention are based on the fact that the CVD apparatus of an endless track, continuous type for manufacturing semiconductor devices comprises the following features: A wafer holder being equipped with a heater equipped with wafer loading surfaces, a rotary shaft for holding said wafer holder to rotate it together with said heater in a circumferential direction in one plane; a gas dispersion unit for discharging a reaction gas, the unit being separated from said wafer holder and having a reaction gas discharging surface facing towards said wafer loading surfaces of said wafer holder, said unit being composed of a plurality of outgassing devices or openings separated from each other; a first pair of electrodes is provided on said rotary shaft and is electrically connected to said heater; and a second pair of electrodes contacts said first pair of electrodes without obstructing the rotation of said rotary shaft, and is connected to a power source.

In other words, the wafer holder is equipped with a heater, the first pair of electrodes electrically connected to the heater are provided on the rotary shaft for rotating the wafer holder, and the second pair of electrodes connected to the power source are brought into contact with the corresponding first pair of electrodes so that the rotation of the rotary shaft is not obstructed. With this, it is possible to move the heater together with the wafer with electric power being supplied to the heater. Accordingly, if the wafer temperature is set at a predetermined temperature at the beginning, it is not required to readjust the wafer temperature until the film formation is complete. Therefore, the wafer temperature is stabilized, thus making it possible to improve the accuracy of the temperature for film formation.

Secondly, the wafer holder has a disc configuration, and has a plurality of wafer loading surfaces along the circumference with the rotary shaft as the center on the surface of the disc. Since it is possible to move the wafer on what is called an endless track, it is possible to form films continuously or intermittently and to maintain a high throughput.

Thirdly, the wafer holder is composed of a plurality of wafer loading tables provided separately from one another, and each of the wafer loading tables has wafer loading surfaces along the circumference with the rotary shaft as the center on one plane. With this, it becomes possible to perform production control of individual wafer and formation of multi-layer films of different types, and to perform film formation having flexibility.

Fourthly, the CVD apparatus for manufacturing a semi-conductor device described according to the invention comprises means for rotating the wafer holder with an axis perpendicular to a wafer loading surface at a position where the wafer is held as the center, or means for having the wafer holder move in a straight line in a radial direction of a circle with the axis as the center. In other words, the wafer loading table rotates with an axis perpendicular to a wafer loading surface at a position where the wafer is held as the center, or moves in a straight line in a radial direction of a circle with the axis as the center. With this, even in case there is a deviation in the supply of reaction gas in one outgassing surface, the supply of the reaction gas to the wafer is uniformed. Thus, it is possible to form a film having uniform film thickness and film quality on the wafer.

Fifthly, the gas dispersion unit of the CVD apparatus of this invention is composed of a plurality of outgassing units installed separately from one another, and has means for supplying reaction gas independently to respective outgassing units, respectively. Thus, it becomes possible to perform production control of individual wafer and formation of multi-layer films of different types similarly to the case that a plurality of wafer loading tables of the wafer holder are provided separately from one another.

In the following the present invention is described with reference to the accompanying drawings, discussing preferred embodiments. In this drawings:
Fig. 1 is a structural view for explaining a CVD apparatus according to a first embodiment of the present invention;
Fig. 2 is a perspective view showing the detail of an electric contact for supplying electric power to a heater, provided on a rotary shaft of a CVD apparatus according to the first embodiment of the present invention;
Fig. 3 shows views for explaining the detail of a gas dispersion unit/a wafer holder in a second embodiment of the present invention;
Fig. 4 is a top view for explaining the detail of a wafer holder in the second embodiment of the present invention;
Fig. 5 is a top view for explaining the detail of a gas dispersion unit in the second embodiment of the present invention;
Fig. 6 is a perspective view for explaining the detail of a gas dispersion unit/a wafer holder in a third embodiment of the present invention;
Fig. 7 shows perspective views for explaining schematic configurations of a gas dispersion unit/a wafer holder in the second to the fifth embodiments of the present invention;
Fig. 8 shows perspective views for explaining schematic configurations of a gas dispersion unit/a wafer holder in the sixth to the ninth embodiments of the present invention;
Fig. 9 shows diagrams for explaining a method for manufacturing a semiconductor device using a CVD apparatus in an embodiment of the present invention;
Fig. 10 shows structural views (-1) for explaining a conventional CVD apparatus; and
Fig. 11 shows a structural view (-2) for explaining a conventional CVD apparatus.

Embodiments of the present invention will be described hereinafter with reference to the drawings.

### (1) The first embodiment

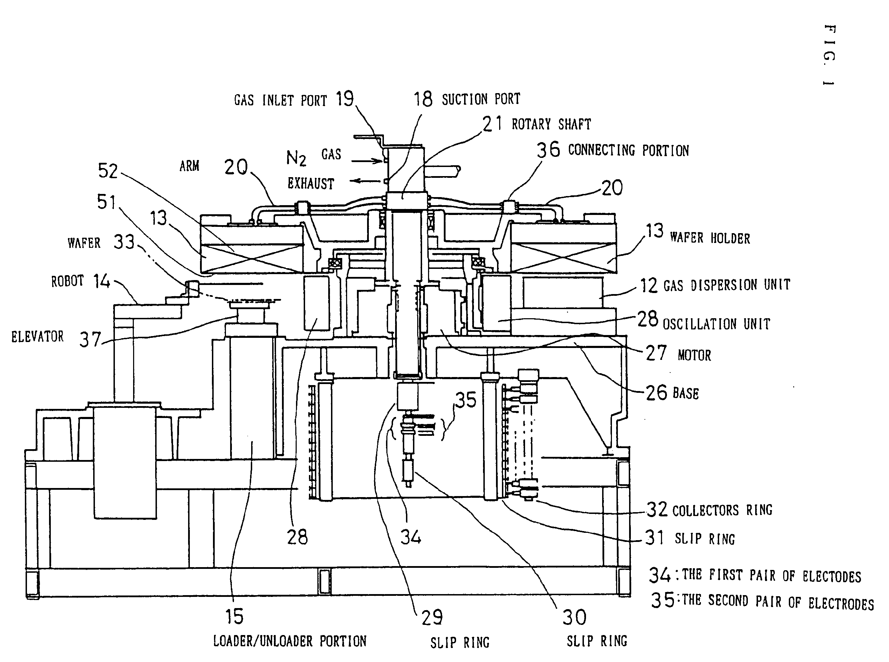

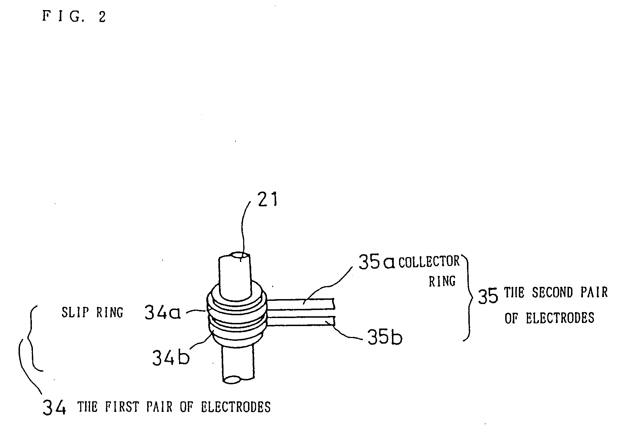

Fig. 1 and Fig. 2 are structural views for explaining a general configuration of a CVD apparatus according to the first embodiment of the present invention, wherein Fig. 1 is a side view and Fig. 2 is a perspective view showing the detail of an electric contact for supplying electric power to a heater 52, provided on a rotary shaft.

In Fig. 1, reference numeral 14 represents a robot for conveying a wafer to a loader/unloader section 15 and/or carrying the wafer out of the loader/ unloader section 15, which can move rotatively and vertically. The loader/unloader section 15 of the CVD apparatus loads the conveyed wafer on an elevator 37 installed, moves the elevator 37 vertically and rotatively, and loads the wafer on a wafer loading surface of an individual wafer holder 13e sometimes and unloads the wafer complete with film formation from the wafer loading surface 51 sometimes.

A reference numeral 13 represents a wafer holder, which fixes a wafer onto a wafer loading surface 51 sometimes and unloads the fixed wafer from the wafer loading surface sometimes by means of a chuck communication with a suction port 18 and a nitrogen gas inlet port 19 connected to an exhauster not illustrated through a pipe-shaped arm 20. Also, a heater is buried in the wafer loading table 13 so as to heat and thermally insulate the loaded wafer. 21 represents a rotary shaft formed in one body with the wafer holders 13, and respective wafer holders 13 are fixed to the rotary shaft 21 by means of the arm 20. Further, the wafer loading surfaces are made to rotate around the rotary shaft 21 on one plane including the wafer loading surfaces of the wafer holders 13 by rotating the rotary shaft 21.

12 represents a gas dispersion unit installed so as to oppose to the wafer loading surface of the wafer holder 13. The gas dispersion unit 12 is provided separately from the wafer holder 13, and fixed to a base 26 of the apparatus. The rotary shaft 21 holding the wafer holder 13 at one end thereof is fitted rotatably at the central part of the base 26, and the other end of the rotary shaft 21 is housed inside the base 26.

27 represents a motor, e.g., a direct drive motor, for rotating the rotary shaft 21, and 28 represents oscillation units for having the wafer holder 13 be in reciprocating and straight-line motion at a constant period in a radial direction with respect to the rotary shaft 21 as the center with the position where the wafer holder 13 is held as reference, wherein joint section 36 of the arm expand and contract in accordance with the reciprocating and straight-line motion. 29 represents a slip ring provided at other end of the rotary shaft 21 for transmitting an electric signal to a solenoid valve for changing over the suction port 18 to and from the inlet port 19, and 30 represents a slip ring for taking out a signal of a thermocouple for measuring the temperature of the heater. 31 represents a slip ring in contact with a collector ring 32 connected to a power source not illustrated for supplying d.c. or a.c. power to the heaters of the wafer holders 13 which rotate together with the rotary shaft 21, and this slip ring 31 is connected further to a pair of collector rings (the second pair of electrodes) 35a and 35b in contact so as to correspond to positive/negative polarities of a pair of slip rings (the first pair of electrodes) 34a and 34b which are fixed to the rotary shaft 21 and rotate together with the rotary shaft 21 as shown in Fig. 2. Besides, in case a plurality of heaters are provided individually, it is also possible to provide a plurality pair of slip rings 34 on the rotary shaft 21 corresponding to respective heaters. Further, a rotary connector is employed to any one of slip rings 29, 30, 34a and 34b so that the rotation of the rotary shaft 21 is not obstructed.

According to a CVD apparatus in the first embodiment of the present invention as described above, the wafer holder 13 is equipped with a heater 52, and a pair of collector rings 35a and 35b connected to a power source are brought into contact with the pair of slip rings 34a and 34b connected to the heater 52 and rotating together with the rotary shaft 21 so that the rotation of the rotary shaft 21 is not obstructed.

Thus, since the wafer can be moved on what is called an endless track, it is possible to form films continuously or intermittently and to maintain a high throughput. Further, the heater can be moved together with the heater 52 with electric power being supplied to the heater. Therefore, if the wafer temperature is set at a predetermined temperature at the beginning, it is not required to readjust the wafer temperature until the film formation is complete. Accordingly, the wafer temperature is stabilized, thus making it possible to improve the accuracy of the temperature for film formation.

### (2) The second to the ninth embodiments

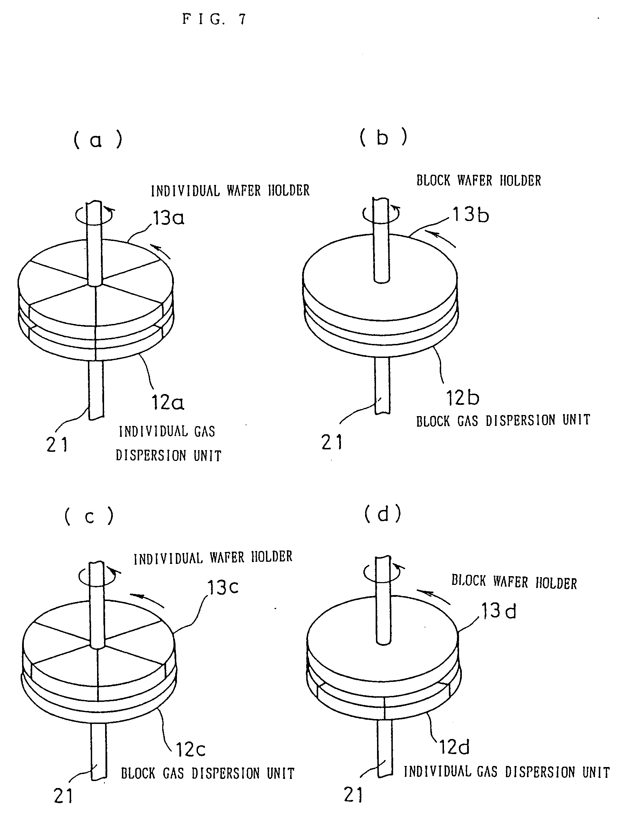

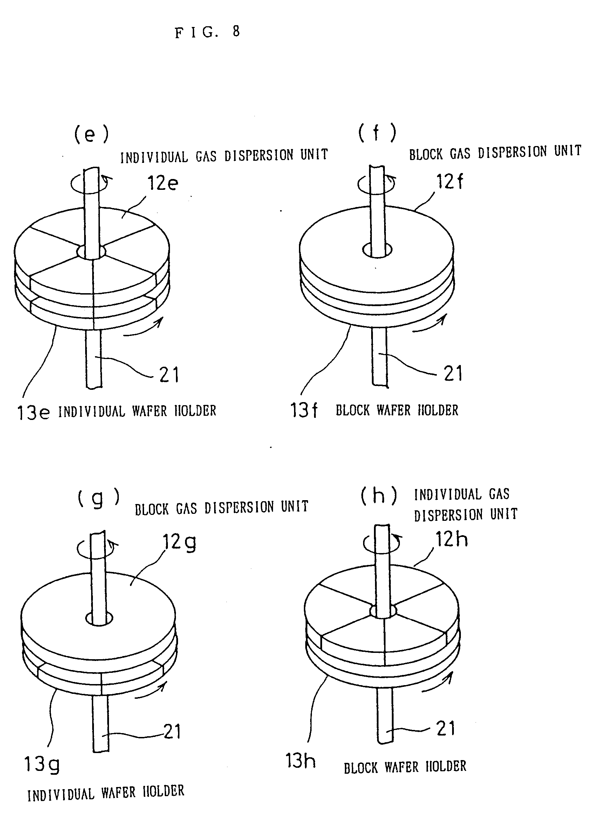

Figs. 7(a) to (d) and Figs. 8(e) to (h) are schematic perspective views collectively illustrating configurations of gas dispersion units/wafer holders of CVD apparatus according to the second to the ninth embodiments of the present invention, respectively. That is:
(a) CVD apparatus having a wafer loading surface facing downward.
   (i) individual gas dispersion unit 12a/individual wafer holder 13a (Fig. 7(a))
   (ii) block gas dispersion unit 12b/block wafer holder 13b (Fig. 7(b))
   (iii) block gas dispersion unit 12c/individual wafer holder 13c (Fig. 7(c))
   (iv) individual gas dispersion unit 12d/block wafer holder 13d (Fig. 7(d))
(b) CVD apparatus having a wafer loading surface facing upward.
   (i) individual gas dispersion unit 12e/individual wafer holder 13e (Fig. 8(e))
   (ii) block gas dispersion unit 12f/block wafer holder 13f (Fig. 8(f))
   (iii) block gas dispersion unit 12g/individual wafer holder 13g (Fig. 8(g))
   (iv) individual gas dispersion unit 12h/block wafer holder 13h (Fig. 8(h))

Respective CVD apparatus having various combinations of above-mentioned gas dispersion units/wafer holders will be described in detail hereinafter.

### (a) The second embodiment

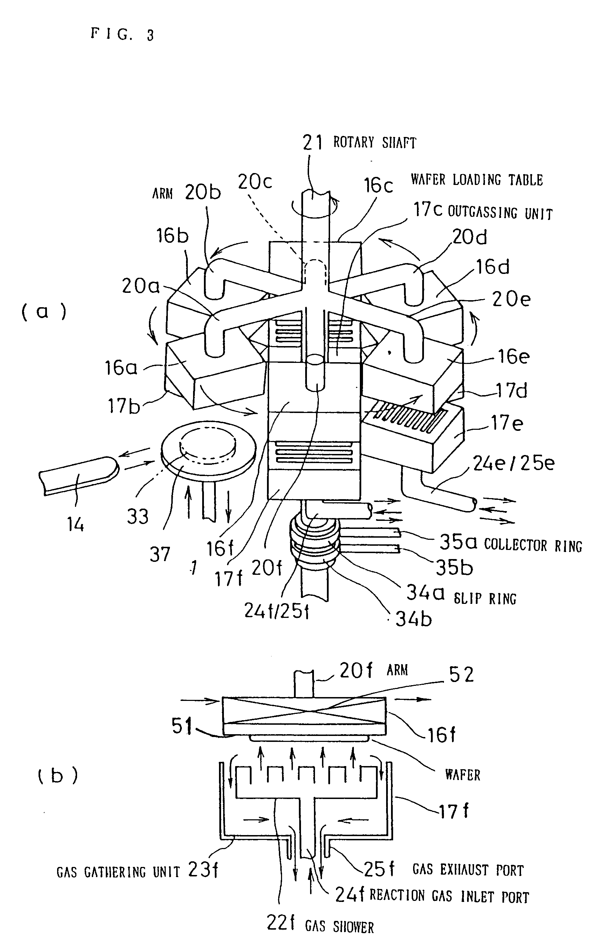

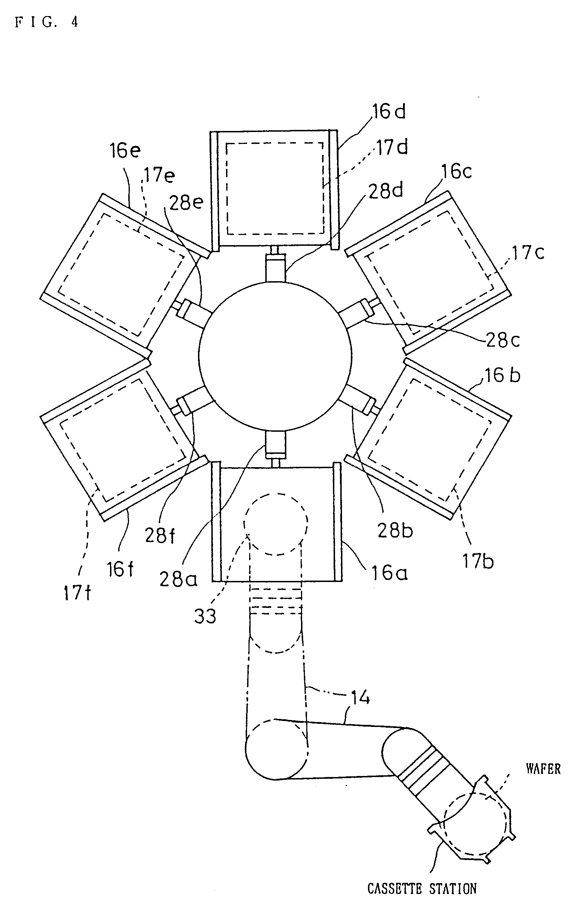

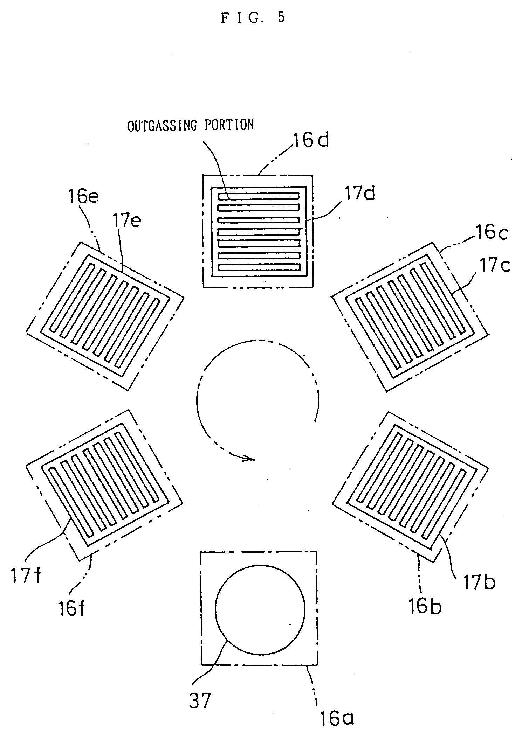

Fig. 3 to Fig. 5 are structural views for explaining configurations of the gas dispersion unit 12/wafer holder 13 and the peripheral portion thereof in the second embodiment of the present invention. Figs. 3(a) and (b) show an individual gas dispersion unit 12a/individual wafer holder 13a shown in Fig. 7(a) and the peripheral portion thereof, Fig. 4 is a top view of the individual wafer holder 13a, and Fig. 5 is a top view of an individual gas dispersion unit 12a.

In Figs. 3(a) and (b), 16a to 16f represent mutually separated wafer loading tables of the individual wafer holder 13a shown in Fig. 7(a), and fix the wafer onto the wafer loading surface and/or unload the fixed wafer from the wafer loading surface by means of chucks communicating with the suction port 18 and the inlet port 19 of nitrogen gas shown in Fig. 1 both connected with an exhauster not illustrated through pipe-shaped arms 20a to 20f.

Further, a heater is buried individually in respective wafer loading tables 16a to 16f so that electric power may be supplied to respective heaters independently so as to heat and thermally insulate the wafers loaded on respective wafer loading tables 16a to 16f. Further, respective wafer loading tables 16a to 16f are fixed to the rotary shaft 21 by means of the arms 20a to 20f. Also, the wafer loading surfaces are arranged so as to rotate around the rotary shaft 21 on one plane including wafer loading surfaces of respective wafer loading tables 16a to 16f by rotating the rotary shaft 21.

17b to 17f represent outgassing units provided so as to oppose to wafer loading surfaces of the wafer loading tables 16a to 16f, which are provided separately from the wafer loading tables 16a to 16f and fixed to the base 26 shown in Fig. 1. Further, respective outgassing units 17b to 17f have gas showers 22b to 22f for supplying the reaction gas to the wafers and gas gathering units 23b to 23f for gathering gas complete with reaction as shown typically by the gas outgassing unit 17f shown in Fig. 3(b), and reaction gas inlet ports 24b to 24f are connected to the gas showers 22b to 22f and gas exhaust ports 25b to 25f are connected to the gas gathering units 23b to 23f.

Further, the slip ring 31 in Fig. 1 connected to the power source is connected to a pair of collector rings (the second pair of electrodes) 35a and 35b which are in contact so as to correspond to positive and negative polarities of the slip rings (the first pair of electrodes) 34a and 34b provided on the rotary shaft 21 and rotating together with the rotary shaft 21. Besides, only the slip rings 34a and 34b connected to the heater of the wafer loading table 16a are shown in Fig. 3(a), but slip rings connected to the heaters of another wafer loading tables 16b to 16f are also provided on the rotary shaft 21. Further, a rotary connector is employed at an electric contact section of any one of slip rings 29, 30, 34a and 34b so that the rotation of the rotary shaft 21 is not obstructed.

Furthermore, in Fig. 4, 28a to 28f represent oscillation units provided separately from the base 26 and rotating along with the rotation of the rotary shaft 21. These oscillation units 28a to 28f conduct movement of the wafer loading tables 16a to 16f in a radial direction with the rotary shaft 21 as the center, respectively, i.e. the reciprocating straight-line movement with the position where the wafer loading tables 16a to 16f are held as the center. Here, the wafer loading table 16a is positioned at the loader/unloader portion 15 where the elevator 37 is installed as shown in Fig. 1, and a wafer is delivered from the robot 14 and the film is not formed.

Further, in Fig. 5, 17b to 17f represent outgassing units provided so as to oppose to the wafer loading tables 16a to 16f shown in Fig. 4. The outgassing units are provided fixedly along a circumference with the rotary shaft 21 as the center, and outgassing portions of respective outgassing units 17b to 17f are provided while being divided into a plurality of slits in a direction perpendicular to the radial direction with the rotary shaft 21 as the center.

In an apparatus for manufacturing a semiconductor device in the second embodiment as described above, it becomes possible to perform production control of individual wafer and formation of multi-layer films of different types by providing a plurality of wafer loading tables 16a to 16f and outgassing units 17b to 17f being mutually separated.

Further, respective wafer loading tables 16a to 16f perform reciprocating and straight-line movement individually on one plane in a direction perpendicular to the array of slit-form outgassing portions. Accordingly, even when there is a deviation in the supply of the reaction gas in one outgassing unit 17b ..., or in an outgassing surface of 17f, the supply of the reaction gas to the wafer is made uniform, thus making it possible to form a film having uniform film thickness and film quality on the wafer.

Besides, the above-described second embodiment includes a wafer loading surface facing downward, the present invention is also applicable to that which includes a wafer loading surface facing upward shown in Fig. 8(c) as the fourth embodiment.

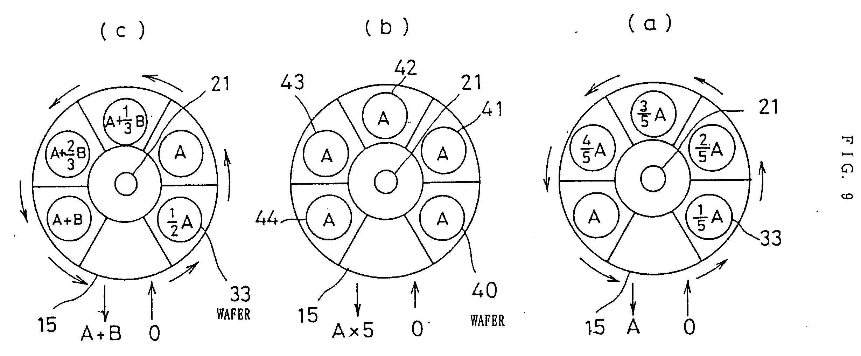

Next, a method for forming an insulating film composed of two layers by using the CVD apparatus shown in Fig. 1 having above-described individual gas dispersion unit 12a/individual wafer holder 13a will be described with reference to Fig. 1 to Fig. 4 and Fig. 9(c). In this case, an insulating film composed of two layers of CVD SiO₂ film/PSG film having a predetermined film thickness is formed on the wafer 33 while the individual wafer holder 13a goes around the rotary shaft 21 as shown in Fig. 9(a). Besides, in Fig. 9(c), A indicates a predetermined film thickness of a CVD SiO₂ film formed on the wafer 33, and B indicates a predetermined film thickness of a PSG film.

First, the first wafer 33 is transported to the loader/unloader portion 15 from the cassette station and loaded on the elevator 37 by means of the robot 14.

Then, the elevator 37 is lifted so as to have the first wafer 33 come in contact with the wafer loading surface of the wafer loading table 16a shown in Fig. 3(a), gas is exhausted through the suction port 18, a signal is transmitted to the slip ring 29 corresponding to the chuck of the wafer loading table 16a, and the solenoid valve is opened so as to load an fix the first wafer 33 onto the wafer loading surface by means of the chuck. At this time, electric power is supplied to the heaters of all the wafer loading tables 16a to 16f through the collector rings 35a, 36b, ... corresponding to the heaters of respective wafer loading tables 16a to 16f, thereby to maintain the temperature of the wafer loading surfaces of all the wafer loading tables 16a to 16f at approximately 350°C.

Next, after the temperature of the first wafer 33 reaches approximately 350°C, the rotary shaft 21 is rotated and the wafer loading table 16a is stopped at a position immediately above the outgassing unit 17f, and at the same time, mixed gas of TEOS-O₃ is discharged from the gas shower 22f as the reaction gas. At this time, the growth rate of the SiO₂ film reaches approximately 2,000 Å, and a SiO₂ film having a film thickness of approximately 2,000 Å, which is about half of a target film thickness, is formed on the first wafer 33. Further, since the wafer loading table 16a is in reciprocating straight-line motion in a radial direction with a position where it is held as the center during film formation, the reaction gas is supplied uniformly onto the first wafer 33 and the film thickness and the film quality of the formed SiO₂ film becomes uniform. In the meantime, the second wafer is loaded on the wafer loading table 16b located at the loader/unloader portion 15 similarly to the above, and is heated so that the temperature of the second wafer reaches approximately 350°C.

Next, the rotary shaft 21 is rotated, and the wafer loading tables 16b and 16a are stopped at positions immediately above the outgassing units 17f and 17e, respectively. Since the second wafer has already reached the temperature of approximately 350°C, it is possible to start film formation immediately. Thus, when mixed gas of TEOS-O₃ is discharged immediately as the reaction gas from the gas showers 22f and 22e and this state is maintained for about one minute, a SiO₂ film having a target film thickness of approximately 4,000 Å is formed on the first wafer 33 and a SiO₂ film having a film thickness of approximately 2,000 Å which is about half of the target film thickness is formed on the second wafer. Besides, in the interim, the third wafer is loaded on the wafer loading table 16c positioned at the loader/unloader portion 15 and the third wafer is heated to approximately 350°C.

Then, the rotary shaft 21 is rotated, and the wafer loading tables 16c, 16b and 16a are stopped at positions immediately above the outgassing units 17f, 17e and 17d, respectively. Since the third wafer has already reached the temperature at approximately 350°C at this time, it is possible to start film formation immediately. Thus, when mixed gas of TEOS-O₃ and TMPO is discharged immediately as the reaction gas from the gas showers 22f, 22e and 22d and this state is maintained for about one minute, a PSG film having a film thickness of approximately 2,000 Å which is about one-third of the target film thickness is formed on the first wafer 33, and a SiO₂ film having a target film thickness of approximately 4,000 Å is formed on the second wafer. Furthermore, a SiO₂ film having a film thickness of approximately 2,000 Å which is about half of the target film thickness is formed on the third wafer.

In this manner, the wafers are set to the wafer loading tables 16d to 16f and sent one by one, and an insulating film composed of two layers SiO₂ film/PSG film is formed on the wafer. Then, when the first wafer 33 returns to the loader/unloader portion 15, after going around the rotary shaft 21 again, SiO₂ film/PSG film having a target film thickness is formed on the first wafer 33. Since the wafer temperature is always maintained at a constant temperature in the meanwhile, the stability of the wafer temperature for film formation is very high.

Next, when the elevator 37 is lifted, a signal is sent to the slip ring 29 corresponding to the chuck of the wafer loading table 16a, the solenoid valve of the suction port 18 is closed, and nitrogen gas is sent to the chuck by opening the inlet port 19 of nitrogen gas, the first wafer 33 leaves the wafer loading surface and is loaded on the elevator. Then, the first wafer 33 is carried out to the cassette station by means of the robot 14. In such a manner, the SiO₂ film/PSG film having a predetermined film thickness is formed on the wafer one by one and accumulated in the cassette station.

As described above, according to the method of forming a SiO₂ film using the method for manufacturing a semiconductor device in the second embodiment, the time for loading/unloading becomes unnecessary practically, thus making it possible to maintain a high throughput.

Further, it becomes possible to control production of individual wafer by providing a plurality of wafer loading tables 16a to 16f and outgassing units 17b to 17f being separated mutually.

Furthermore, a plurality of wafer loading tables 16a to 16f are made to perform straight-line reciprocating movement individually on the above-mentioned plane with respective positions where they are held as centers. Therefore, even if there is a deviation in the supply of the reaction gas, the reaction gas is supplied to the wafer uniformly. Further, since the heaters are moved together with the wafers, the wafer temperature is maintained always constant, thus obtaining high stability of the temperature. With this, it is possible to form a wafer having uniform film thickness and film quality on the wafer.

Besides, in the above-mentioned method for manufacturing a semiconductor device, an insulating film composed of two layers is formed by using two types of reaction gases. As shown in Fig. 9(a), however, it is also possible to form a single film on the wafer while the wafer goes around by flowing one type of reaction gas to predetermined outgassing units 17b to 17f.

Further, as shown in Fig. 9(b), it is also possible to form a single film by a method similar to such a batch system that films are formed simultaneously on the wafers 40 to 44 using one type of reaction gas after setting wafers in advance to all the wafer loading tables 16a to 16f.

### (b) The third embodiment

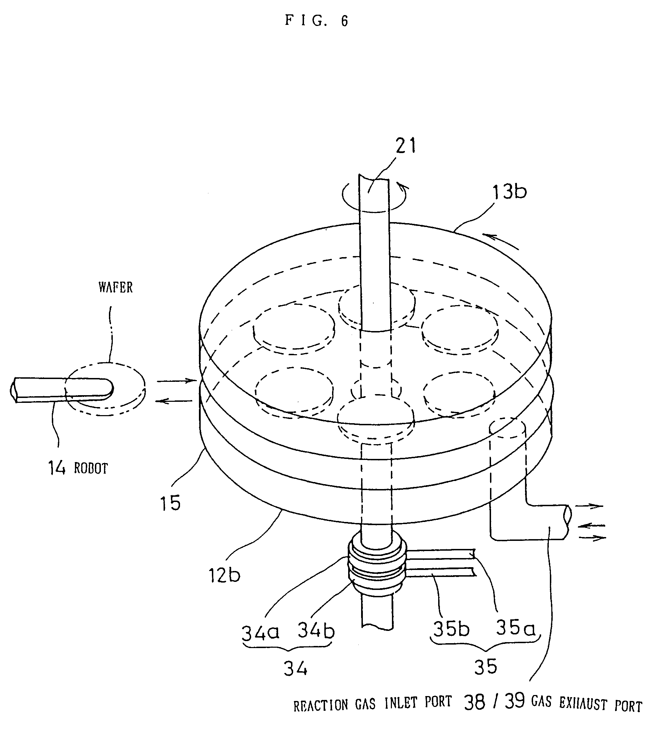

Fig. 6 is a structural view for explaining in detail the configuration of gas dispersion unit/wafer holder in the third embodiment of the present invention, which is used for the CVD apparatus shown in Fig. 1. The configuration includes a combination of block outgassing unit 12b/block wafer holder 13b shown in Fig. 7(b).

In Fig. 6, 13b represents a disc wafer holder, and the wafer holder 13b is fixed to the rotary shaft 21 at the central part of the disc, and the disc surface around the rotary shaft 21 is formed as a wafer loading surface on which a plurality of wafers can be loaded, where the wafers are loaded in a form of facing downward. One set of heater is buried in a top part of this wafer loading surface so as to surround the rotary shaft 21 and is not split. Further, the wafers on the wafer loading surface are heated and thermally insulated by the heater. 12b represents a disc gas dispersion unit fixed to the base 26 being separated from the rotary shaft 21 and the wafer holder 13b and provided so as to oppose to the wafer loading surface of the wafer holder 13b, and radial slits with the rotary shaft 21 as the center are provided as outgassing portions in the area opposing to the wafer loading surface. Further, in order to gather the reaction gas discharged from the outgassing portions, a gas gathering unit resembling to that shown in Fig. 3(b) is provided in the circumferential portion of outgassing portions so as to surround the outgassing portion. Further, 14 represents a robot for loading a wafer on the wafer loading surface of the wafer holder 13b which has arrived at the position of the loader/unloader portion 15 and having a wafer leave the wafer loading surface of the wafer holder 13b which has arrived at the position of the loader/unloader portion 15.

In the apparatus for manufacturing a semiconductor device in the third embodiment of the present invention, the time of loading/unloading becomes practically unnecessary, thus making it possible to maintain a high throughput.

Further, since it is possible to move the heater together with the wafer, the wafer temperature is maintained always constant, thus resulting in high stability of the temperature. With this, it is possible to form a film having uniform film thickness and film quality on the wafer.

Besides, a wafer loading surface facing downward is provided in the above-mentioned third embodiment, but the present invention is also applicable to that having the wafer loading surface facing upward shown in Fig. 8(f) as a fifth embodiment.

Next, a method for forming a single CVD SiO₂ film on the wafer using the above-mentioned CVD apparatus will be described with reference to Fig. 1, Fig. 2, Fig. 6 and Fig. 9(b). In this case, as shown in Fig. 9(b), a plurality of wafers are loaded in advance on the wafer holder 13b at the same time, and a single CVD SiO₂ film having a predetermined film thickness is formed while the wafer holder 13b goes around the rotary shaft. Namely, the method resembles to a method for forming a film by batch processing. Besides, in Fig. 9(b), A indicates a target film thickness of the CVD SiO₂ film. Further, a case that the oscillation units are not provided will be described in the present embodiment.

First, a signal is sent to the slip ring 29 corresponding to the chuck of each wafer loading surface, five sheets of wafers 40 to 44 are carried to the loader/unloader portion and loaded on the wafer loading surface of the wafer holder 13f in consecutive order by means of the robot 14 while exhausting the gas from the suction port 18 by opening the solenoid valve, and respective wafers 40 to 44 are fixed to the wafer loading surface by means of the chuck. Furthermore, electric power is supplied to the heater so as to heat the wafers 40 to 44 on the wafer loading surface.

Next, after the temperature of respective wafers has reached approximately 350°C, mixed gas of TEOS-O₃ is discharged as the reaction gas from the outgassing portion of the gas dispersion unit 12b, and the rotary shaft 21 is rotated at a speed of going around in about one minute while maintaining the wafer temperature at approximately 350°C. Now, when the film formation rate is set to approximately 2,000 Å/min, a CVD SiO₂ film having a target film thickness of approximately 8,000 Å is formed uniformly on respective wafers 40 to 44 after the rotary shaft 21 goes around four times.

Next, after the reaction gas supplied to the gas dispersion unit 12 is stopped, the wafers 40 to 44 are removed one by one from the wafer holder 13b by a procedure reverse to the loading of the wafers 40 to 44. In other words, a signal is sent to the slip ring 29 corresponding to the chuck of the wafer holder 13b thereby to close the solenoid valve of the suction port 18, and at the same time, the valve of the inlet port 19 of nitrogen gas is opened thereby to send the nitrogen gas to the chuck. Thus, respective wafers 40 to 44 are unloaded from the wafer loading surface, and carried out to the cassette station in consecutive order by means of the robot 14. It is thus possible to form CVD SiO₂ films having a predetermined film thickness on the wafers 40 to 44 at a time.

As described above, according to the method of forming a CVD SiO₂ film using the CVD apparatus of the third embodiment, the throughput is limited because time is required for loading/unloading. Since only one system will suffice for power supply to the feed pipings of the reaction gas and the heaters, however, operation and maintenance of the apparatus can be performed easily.

Further, the heater is moved together with the wafer. Thus, the wafer temperature is maintained always constant and stability of the temperature is high. With this, it is possible to form a film having uniform film thickness and film quality on a wafer.

Incidentally, according to the above-mentioned method for manufacturing a semiconductor device, the films are formed by a method resembling to a batch system in which the films are formed on the wafers 40 to 44 at the same time after setting the wafers 40 to 44 in advance on all the wafer loading surfaces of the wafer holder 13. However, it is also possible to set the wafers to the wafer holder 13b in consecutive order and to form a film having a predetermined film thickness while the wafer goes around the rotary shaft 21 as shown in Fig. 9(a).

Further, it is also possible to obtain block gas dispersion units 12c, 12g/individual wafer holders 13c, 13g and individual gas dispersion units 12d, 12h/block wafer holders 13d, 13h shown in Figs. 7(c) and (d) and Figs. 8(g) and (h) by combining gas dispersion units and wafer holders in the second and the third embodiments as the 6th to the 9th embodiments. By doing so, it is possible to form a film by a method- suited to various types of film formation.

Furthermore, an apparatus for manufacturing a semiconductor device is applied to film formation under atmospheric pressure in the above-mentioned embodiments, but it may also be applied to film formation under reduced pressure by a plasma CVD method and the like.

As described above, a CVD apparatus for manufacturing a semiconductor device according to the present invention is useful as an apparatus for forming a film such as a continuous type automated CVD apparatus. In particular, it is suitable for forming films continuously while preventing variation of the wafer temperature when the wafers are being moved and for performing production control of individual wafer and formation of multi-layer films of different types.

Hereinafter, a reference list is given, to show which reference numerals pertains to which object.

1 ... conveyor belt; 2 ... heater; 3, 12 ... gas dispersion units; 4a, 4b ... cassette stations; 5 ... chamber; 6a - 6h ... wafer loading tables; 7a - 7h ... walking beams; 8a, 8b ... gate valves; 9 ... load lock chamber; 10 ... cassette chamber; 11, 26 ... bases; 12a, 12d, 12e, 12h ... individual gas dispersion units; 12b, 12c, 12f, 12g ... block gas dispersion units; 13 ... wafer holder; 13a, 13c, 13e, 13g ... individual wafer holders; 13b, 13d, 13f, 13h ... block wafer holders; 14 ... robot; 15 ... loader/unloader portion; 16a - 16f ... wafer loading tables; 17b - 17f ... outgassing units; 18 ... suction port; 19 ... gas inlet port; 20 ... arm; 21 ...rotary shaft; 22b - 22f ... gas showers; 23b - 23f ... gas gathering units; 24b - 24f, 38 ... reaction gas inlet ports; 25b - 25f, 39 ... gas exhaust ports; 27 ... motor; 28 ... oscillation unit; 29, 30, 31, 34a, 34b ... slip rings; 32, 35a, 35b ... collector rings; 33 ... wafer; 34 ... the first pair of electrodes; 34a, 34b ... susceptors; 35 ... the second pair of electrodes; 36 ... connecting portion; 37 ... elevator.

## Claims

1. A CVD apparatus of an endless track, continuous type for manufacturing semiconductor devices, comprising:
a wafer holder (13) equipped with a heater (52) equipped with wafer loading surfaces (51);
a rotary shaft (21) for holding said wafer holder (13) to rotate it together with said heater (52) in a circumferential direction in one plane;
a gas dispersion unit (12) for discharging a reaction-gas, the unit (12) being separated from said wafer holder (13) and having a reaction-gas discharging surface facing towards said wafer loading surfaces (51) of said wafer holder (13), said unit (12) being composed of a plurality of outgassing devices or openings separated from each other;
a first pair of electrodes (34a, 34b) provided on said rotary shaft (21) and electrically connected to said heater (52); and
a second pair of electrodes (35a, 35b) contacting said first pair of electrodes (34a, 34b) without obstructing the rotation of said rotary shaft (21) and connecting a power source.

2. A CVD apparatus for manufacturing a semiconductor device according to claim 1, wherein said wafer holder (13) has a disc configuration, and has a plurality of wafer loading surfaces (51) along a circumference on the plate surface of the disc.

3. A CVD apparatus for manufacturing a semiconductor device according to claim 1, wherein said wafer holder (13) is composed of a plurality of wafer loading tables (16a-16f) being separated from one another, having respective wafer loading surfaces (51), and being provided along a circumference with said rotary shaft (21) as the center.

4. A CVD apparatus for manufacturing a semiconductor device according to claim 3, comprising means for rotating each of said wafer loading tables (16a-16e) with a shaft perpendicular to said wafer loading surface (51) at positions where it is held as the center, or means for moving the respective wafer loading tables (16a-16f) in radial direction of a circle with the shaft as the center.

5. A CVD apparatus for manufacturing a semiconductor device according to any one of claims 1 to 4, wherein said outgassing devices (17b-17f) have respective reaction gas inlet ports (24b-24f).

## Patentansprüche

1. CVD-Einrichtung vom kontinuierlichen Endlosbahn-Typ zur Herstellung von Halbleiter-Bauteilen mit
- einem Waferhalter (13), der mit einer Heizeinrichtung (52) ausgestattet ist, welche mit Wafer-Beladeoberflächen (51) versehen ist;
- einer Drehwelle (21) zum Halten des Wafer-Halters (13), um ihn zusammen mit der Heizeinrichtung (52) in einer Umfangsrichtung in einer Ebene zu drehen;
- einer Gasdispersionseinheit (12) zur Abgabe eines Reaktionsgases, wobei die Einheit (12) von dem Waferhalter (13) getrennt ist und eine Reaktionsgas-Abgabeoberfläche hat, die den Wafer-Beladeoberflächen des Waferhalters (13) zugewandt ist, wobei die Einheit (12) aus mehreren Ausgasungsvorrichtungen oder -öffnungen zusammengesetzt ist, die voneinander getrennt sind;
- einem ersten Elektrodenpaar (34a, 34b), das auf der Drehwelle (21) vorgesehen und elektrisch mit der Heizeinrichtung (52) verbunden ist; und
- einem zweiten Elektrodenpaar (35a, 35b), das mit dem ersten Elektrodenpaar (34a, 34b) in Kontakt ist, ohne die Drehung der Drehwelle (21) zu behindern, und das mit einer Energiequelle verbunden ist.

2. CVD-Einrichtung zur Herstellung eines Halbleiter-Bauteils gemäß Anspruch 1, bei der der Waferhalter (13) als Scheibe ausgebildet ist und mehrere Wafer-Beladeoberflächen (51) entlang eines Umfangs der Plattenoberfläche der Scheibe hat.

3. CVD-Einrichtung zur Herstellung eines Halbleiter-Bauteils gemäß Anspruch 1, bei der der Waferhalter (13) aus mehreren Wafer-Beladetischen (16a-16f) zusammengesetzt ist, die voneinander getrennt sind, jeweilige Beladeoberflächen (55) haben und entlang eines Umfangs mit der Drehwelle (21) als Mittelpunkt vorgesehen sind.

4. CVD-Einrichtung zur Herstellung eines Halbleiter-Bauteils gemäß Anspruch 3 mit Einrichtungen zum Drehen eines jeden der Wafer-Beladetische (16a-16e), mit einer an Positionen, wo sie als Zentrum gehalten wird, zur Wafer-Beladeoberfläche (51) rechtwinkligen Welle, oder mit Einrichtungen zum Bewegen der jeweiligen Wafer-Beladetische (16a-16f) in Radialrichtung eines Kreises mit der Welle als Mittelpunkt.

5. CVD-Einrichtung zur Herstellung eines Halbleiter-Bauteils gemäß einem der Ansprüche 1 bis 4, bei der die Ausgasungsvorrichtungen (17b-17f) jeweilige Reaktionsgas-Einlaßöffnungen (24b-24f) haben.

## Revendications

1. Dispositif de dépôt chimique en phase vapeur (CVD) d'un type continu à voie sans fin, pour la fabrication de dispositifs semiconducteurs, comprenant:
un support de tranches (13) équipé d'un élément chauffant (52) équipé de surfaces de chargement de tranches (51);
un arbre rotatif (21) pour maintenir ledit support de tranches (13) pour le faire tourner en même temps que ledit élément chauffant (52) dans une direction circonférentielle dans un plan;
une unité de dispersion de gaz (12) pour décharger un gaz de réaction, l'unité (12) étant séparée dudit support de tranches (13) et comprenant une surface de décharge de gaz de réaction tournée vers lesdites surfaces de chargement de tranches (51) dudit support de tranches (13), ladite unité (12) étant composée d'une pluralité de dispositifs ou d'ouvertures de dégazage séparés les uns des autres;
une paire d'électrodes (34a, 34b) prévues sur ledit arbre rotatif (21) et reliées électriquement audit élément chauffant (52); et
une seconde paire d'électrodes (35a, 35b) venant en contact avec ladite première paire d'électrodes (34a, 34b) sans faire d'obstruction à la rotation dudit arbre rotatif (21) et reliées à une source de puissance.

2. Dispositif CVD pour la fabrication d'un dispositif semiconducteur selon la revendication 1, dans lequel ledit support de tranches (13) a une configuration en forme de disque, et comprend une pluralité de surfaces de chargement de tranches (51) le long d'une circonférence sur la surface plane du disque.

3. Dispositif CVD pour la fabrication d'un dispositif semiconducteur selon la revendication 1, dans lequel ledit support de tranches (13) est composé d'une pluralité de tables de chargement de tranches (16a-16f) séparées les unes des autres, comprenant des surfaces de chargement de tranches respectives (51), et étant prévues le long d'une circonférence avec ledit arbre rotatif (51) en tant que centre.

4. Dispositif CVD pour la fabrication d'un dispositif semiconducteur selon la revendication 3, comprenant des moyens pour faire tourner chacune desdites tables de chargement de tranches (16a-16e) avec un arbre perpendiculaire à ladite surface de chargement de tranches (51) dans des positions où il est maintenu en tant que centre, ou des moyens pour déplacer les tables de chargement de tranches respectives (16a-16e) en direction radiale d'un cercle avec l'arbre comme centre.

5. Dispositif CVD pour la fabrication d'un dispositif semiconducteur selon l'une quelconque des revendications 1 à 4, dans lequel lesdits dispositifs de dégazage (17b-17f) comprennent des orifices d'entrée de gaz de réaction respectifs (24b-24f).
